Europäisches Patentamt

**European Patent Office**

**Office européen des brevets**

(11) Veröffentlichungsnummer: **0 687 916 A2**

## (12) EUROPÄISCHE PATENTANMELDUNG

(21) Anmeldenummer: **95201477.7**

(22) Anmeldetag: **06.06.95**

(51) Int. Cl.6: **G01R 31/316**

(30) Priorität: **16.06.94 DE 4420988**

(43) Veröffentlichungstag der Anmeldung:
**20.12.95 Patentblatt 95/51**

(84) Benannte Vertragsstaaten:
**DE FR GB IT**

(71) Anmelder: **Philips Patentverwaltung GmbH**
**Röntgenstrasse 24**
**D-22335 Hamburg (DE)**
(84) **DE**

(71) Anmelder: **Philips Electronics N.V.**
**Groenewoudseweg 1**
**NL-5621 BA Eindhoven (NL)**
(84) **FR GB IT**

(72) Erfinder: **Ernst, Holger, c/o Philips**
**Patentverwaltung GmbH.**
**Wendenstrasse 35c**
**D-20097 Hamburg (DE)**

(74) Vertreter: **Poddig, Dieter, Dipl.-Ing. et al**
**Philips Patentverwaltung GmbH,**
**Röntgenstrasse 24**
**D-22335 Hamburg (DE)**

(54) **Verfahren zum Testen einer integrierten Schaltung sowie integrierte Schaltungsanordnung mit einer Testschaltung**

(57) Integrierte Schaltungen, die insbesondere analoge Signale verarbeiten und aus einer Vielzahl von einzelnen Funktionsblöcken bestehen, sind nur schwierig zu testen, da die Anschlüsse beispielsweise intern miteinander verbundener Funktionsblöcke nicht ohne weiteres herausgeführt werden können, und zwar wegen der begrenzten Anzahl externer Anschlüsse. Um dennoch einen möglichst vollständigen Test der integrierten Schaltung durch Testen einzelner Funktionsblöcke getrennt voneinander zu ermöglichen, wird vorgeschlagen, Eingänge und Ausgänge von Funktionsblöcken mit Schaltern zu verbinden, die eine Verbindung dieser Funktionsblöcke mit externen Anschlüssen ermöglichen. Die Schalter werden durch Speicherstufen angesteuert, und diese werden über einen Testeingang geladen, der mit Komparatoren verbunden ist. Diese vergleichen das Eingangssignal mit verschiedenen Referenzspannungen, wobei die Spannungsbereiche zwischen den Referenzsignalen den logischen Werten "0" und "1" sowie einem Taktsignalwert zugeordnet sind. Dadurch kann über nur einen Testeingang eine Folge von Daten mit einem Datentakt zugeführt werden, um die internen Schalter gemäß dem gewünschten Testzustand umzuschalten.

FIG. 2

EP 0 687 916 A2

Die Erfindung betrifft allgemein das Gebiet des Testens von integrierten Schaltungen nach deren Herstellung auf Funktionsfähigkeit. Insbesondere betrifft die Erfindung das Testen von integrierten Schaltungen, die Wenigstens zum Teil analoge Schaltungen enthalten.

Die heute entwickelten integrierten Schaltungen für die Verarbeitung analoger Signale werden immer komplexer, da ständig mehr Funktionsblöcke zu einer integrierten Schaltung zusammengefaßt werden. Für jeden Funktionsblock sind bestimmte Funktionen und Eigenschaften definiert. Wenn diese Eigenschaften, wie z.B. Frequenzgang oder nichtlineare Funktionen getestet werden sollen, kann dies durch Testen der Signalpfade als Ganzes, die über Anschlüsse von außerhalb zugänglich sind, nur unvollkommen erfolgen, weil dann nur die Eigenschaften mehrerer Funktionsblöcke zusammen erfaßt werden, die sich jedoch häufig gegenseitig beeinflussen. Bei manchen integrierten Schaltungen gibt es zwar Teile des Signalpfades, die außerhalb der integrierten Schaltung verlaufen, z.B. über externe Koppelkondensatoren oder diskrete Filter, so daß in diesem Falle auch Teile des Signalpfades geprüft werden können. Bei modernen integrierten Schaltungen für analoge Signale wird jedoch versucht, möglichst wenige externe Anschlüsse zu verwenden und Angleichvorgänge beim Einsatz solcher integrierten Schaltungen so weit wie möglich zu vermeiden. Dies kann teilweise über zusätzliche interne Regelkreise erfolgen, die jedoch die gegenseitige Beeinflussung der Funktionen der Funktionsblöcke noch verstärken. Andererseits muß der Hersteller einer integrierten Schaltung die Funktionsfähigkeit unter allen zulässigen Randbedingungen garantieren, was zu einem sehr hohen Testaufwand führt.

Eine Testschaltung, die möglichst wenige Testanschlüsse erfordert, ist beispielsweise aus der EP 0 076 734 A2 bekannt, wo verschiedene Spannungspegel zwischen der Betriebsspannung und Bezugspotential der integrierten Schaltung verwendet werden, um Kombinationen von binären Testsignalen einzugeben. Diese bekannte Schaltung ist jedoch offensichtlich für den Test rein digitaler integrierter Schaltungen vorgesehen und gibt keinen Hinweis, in integrierten Schaltungen mit mehreren analogen Funktionsblöcken diese vorzugsweise einzeln zu testen.

Aus der EP 0 141 681 A2 ist ferner eine Schaltungsanordnung mit einem Testeingang bekannt, der beim Zuführen eines Signalpegels etwa in der Mitte zwischen der Betriebsspannung und Bezugsspannung das Einstellen der Schaltung in einen Testzustand ermöglicht. Auch diese Schaltung betrifft offensichtlich das Prüfen einer rein digitalen Schaltung. Bei beiden bekannten Schaltungen ist es lediglich möglich, durch Signalpegel, die zwischen der Betriebsspannung und Bezugspotential liegen, zusätzliche Signale einzugeben, um gesonderte Testanschlüsse einzusparen.

Aufgabe der Erfindung ist es, ein Verfahren zum Prüfen einer integrierten Schaltung anzugeben, das nur eine möglichst geringe Anzahl zusätzlicher Anschlüsse benötigt, um die Funktion von insbesondere analogen internen Funktionsblöcken weitgehend unabhängig von anderen Funktionsblöcken zu testen.

Diese Aufgabe wird erfindungsgemäß dadurch gelöst, daß das Verfahren folgende Schritte enthält:
- es werden über wenigstens einen Testeingang Folgen von Testsignalen zugeführt,
- die Testsignale der Folge werden in der integrierten Schaltung gespeichert zum Ansteuern von Schaltern zwischen verschiedenen Schaltungspunkten der integrierten Schaltung und/oder äußeren Anschlüssen,
- nach jeder Folge von Testsignalen wird wenigstens einem Anschluß ein vorgegebenes Eingangssignal zugeführt, und Eigenschaften des Ausgangssignals an wenigstens einem anderen Anschluß werden mit vorgegebenen Eigenschaften verglichen.

Es werden also Schalter vorgesehen, durch die es möglich wird, von einzelnen Funktionsblöcken die Eingänge und Ausgänge direkt mit äußeren Anschlüssen zu verbinden, um diese isoliert und unbeeinflußt von anderen Funktionsblöcken zu testen. Ferner ist es möglich, durch die Schalter bestimmte Funktionsblöcke im Signalpfad zu umgehen oder interne Steuereingänge von solchen Funktionsblöcken mit einem festen Potential zu verbinden. Die Ansteuerung der Schalter erfolgt über Speicherstufen, die vorzugsweise über nur einen Eingang geladen werden, über den die Testsignale zugeführt werden. Dies können binäre Signalfolgen sein, die derart codiert sind, daß daraus ein Taktsignal zurückgewonnen werden kann, wie dies beispielsweise bei Kanalcodes für CD der Fall ist, so daß auf diese Weise über einen einzigen Eingang beliebige Folgen von Steuersignalen für die Schalter einzugeben sind. Dies erfordert jedoch eine aufwendige Rückgewinnung der Steuersignale.

Eine einfachere Möglichkeit, Steuersignale für die Schalter einzugeben, besteht darin, daß die Testsignale mit einem von mehreren Spannungspegeln in der Form zugeführt werden, daß ein erster Spannungspegel ein logisches Signal "1", ein zweiter Spannungspegel ein logisches Signal "0" und ein dritter Pegel die Trennung zwischen zeitlich aufeinanderfolgenden logischen Signalen darstellt.

Aus derartigen Testsignalen können mit wenig Aufwand die Steuersignale und die Taktsignale abgeleitet werden, wobei nur ein einziger Eingang notwendig ist. Dieser Eingang für die Testsignale ist vorzugsweise ein zusätzlicher Eingang. Es kann jedoch auch ein bereits vorhandener Eingang verwendet werden, wenn über diesen nur Signale zugeführt werden, die entweder Betriebsspannung oder Bezugsspannung haben, wie dies beispielsweise bei Umschaltsignalen für interne Funktionen der Fall ist.

Entsprechend kann auch ein zusätzlicher Ausgang verwendet werden, über den im Testfall alle gewünschten Ausgangssignale ausgegeben werden. Im Normalbetrieb hätte ein solcher Ausgang wie auch ein gesonderter Testeingang keine Funktion. Statt dessen kann auch hier ein Ausgang verwendet werden, über den auch im Normalbetrieb Signale ausgegeben werden. Da bei jedem Testschritt durch Zuführen einer Folge von Testsignalen eine größere Anzahl von Schaltern in eine gewünschte Lage gebracht werden kann, ist ein sehr umfangreicher Test auch von sehr komplexen integrierten analogen Schaltungen möglich.

Ferner besteht die Aufgabe der Erfindung darin, eine integrierte Schaltungsanordnung mit Anschlüssen nach außerhalb und mit einer Testschaltung anzugeben, mit der ein Test einzelner Funktionsblöcke weitgehend unabhängig von anderen Funktionsblöcken, insbesondere mit wenigstens zum Teil analogen Schaltungen, unter Verwendung einer minimalen Anzahl zusätzlicher externer Anschlüsse möglich ist.

Diese Aufgabe wird gemäß der Erfindung dadurch gelöst, daß die Testschaltung über wenigstens einen Taktanschluß nach außerhalb verbunden ist und enthält:

- eine mit dem Testanschluß verbundene Impulsformanordnung zum Abgeben von binären Signalen an einem Steuerausgang und von Taktsignalen an einem Taktausgang,
- eine Anzahl Speicherstufen, die mit dem Steuerausgang und dem Taktausgang gekoppelt sind, um bei jedem Taktsignal am Taktausgang das vorhergehende binäre Signal am Steuerausgang in einer anderen Speicherstufe zu speichern,
- eine Anzahl Schalter zwischen verschiedenen Schaltungspunkten der integrierten Schaltung und/oder Anschlüssen, wobei die Schalter Steuereingänge aufweisen, die mit Ausgängen der Speicherstufen gekoppelt sind.

Bei einer solchen integrierten Schaltungsanordnung ist es möglich, nahezu beliebige Teile der Schaltung einzeln oder wahlweise in Kombination zu testen und dabei bestimmte Parameter für wenigstens einige dieser Teile der Schaltung vorzugeben.

Wenn als Testsignal ein selbsttaktendes binäres Signal eingegeben wird, muß die Impulsformschaltung daraus das Taktsignal zurückgewinnen, wofür ein komplizierter Aufbau der Impulsformschaltung notwendig ist. Wenn jedoch das Testsignal mehrere Spannungspegel aufweist, von denen ein erster und ein zweiter den logischen Signalen "0" bzw. "1" und ein dritter der Trennung zwischen zeitlich aufeinanderfolgenden logischen Signalen zugeordnet ist, kann der Schaltungsaufwand verringert werden, indem die Impulsformschaltung wenigstens einen ersten und einen zweiten Komparator mit je zwei Eingängen und einem Ausgang enthält, wobei der eine Eingang mit dem Testanschluß und der andere Eingang mit einem ersten bzw. einem zweiten Schaltungsknoten für unterschiedliche Referenzspannungen verbunden ist und der Ausgang einen Signalwechsel erzeugt, wenn das Signal jedes Komparators am Testeingang die zugehörige Referenzspannung überschreitet bzw. unterschreitet, und der Ausgang des ersten Komparators mit dem Taktausgang und der Ausgang des zweiten Komparators über eine Verzögerungsschaltung mit dem Steuerausgang gekoppelt ist.

Dadurch ist es möglich, über nur einen Eingang eine Folge von binären Testdaten einschließlich eines Datentaktes zuzuführen, um eine Mehrzahl von Schaltern entsprechend einzustellen.

Eine zweckmäßige Wahl der Referenzspannungen ist dadurch gegeben, daß die Referenzspannung des ersten Schaltungsknotens niedriger ist als die des zweiten Schaltungsknotens. Dadurch können die Signale für die beiden binären Werte der Testdaten und der Datentakt besonders einfach dargestellt und ausgewertet werden. Der Normalbetrieb der integrierten Schaltung kann nach dem Testen dadurch eingestellt werden, daß ein bestimmtes Informationsmuster in die Speicherstufen eingeschrieben wird. Da Speicherstufen jedoch normalerweise flüchtige Informationsspeicher darstellen, die beim Abschalten der Betriebsspannung ihre Information verlieren, müßte die Einstellung der Speicherstufen für die Ansteuerung der Schalter nach jedem erneuten Einschalten erfolgen. Um dies zu vermeiden, ist die erfindungsgemäße Schaltungsanordnung nach einer Ausgestaltung dadurch gekennzeichnet, daß ein dritter Komparator mit zwei Eingängen und einem Ausgang vorgesehen ist, wobei der eine Eingang ebenfalls mit dem Testanschluß und der andere Eingang mit einem dritten Schaltungsknoten für eine Referenzspannung verbunden ist und der Ausgang mit einem Rücksetzeingang aller Speicherstufen verbunden ist, und daß die Steuereingänge der Schalter derart mit den Ausgängen der Speicherstufen verbunden sind, daß die Schalter bei zurückgesetzten Speicherstufen Verbindungen für den normalen Betrieb der integrierten Schaltung herstellen. Auf diese Weise können die Speicherstufen in einen definierten Zustand versetzt werden, indem der Testanschluß innerhalb einer Gesamtschaltung, in der die integrierte Schaltung verwendet werden soll, fest mit einem vorgegebenen Potential verbunden wird. Dadurch wird die integrierte Schaltung automatisch in den normalen Betriebszustand gesetzt. Hierfür ist es zweckmäßig, daß die Referenzspannung des dritten Schaltungsknotens niedriger als die des ersten Schaltungsknotens ist. Der Testanschluß muß dann nur mit dem Bezugspotential verbunden werden, um den normalen Betriebszustand herzustellen. Wenn der Testanschluß über einen Widerstand mit Bezugspotential verbunden ist, kann sogar eine äußere Verbindung des Testanschlusses mit Bezugspotential unterbleiben, wodurch sich unter Umständen die Leitungsführung beim Anschluß einer solchen integrierten Schaltung vereinfacht. Die Eigenschaften der Ausgangssignale können z.B. deren Amplitude, deren Frequenzgang oder auch nur deren Form sein.

Im einfachsten Fall kann jedem Schalter eine Speicherstufe zugeordnet werden. Da sich jedoch häufig bestimmte Schalterstellungen gegeneinander ausschließen, ist es auch möglich, wenigstens einige Schalter über logische Gatter mit Ausgängen mehrerer Speicherstufen zu verbinden. Dadurch können Speicherstufen eingespart werden, und die Folgen binärer Testsignale können kürzer sein.

Das Einschreiben der aufeinanderfolgenden binären Testsignale in unterschiedliche Speicherstufen kann z.B. nach Art eines Verteilers erfolgen. Eine noch einfachere Möglichkeit besteht darin, daß die Speicherstufen in Form eines Schieberegisters zusammengeschaltet sind.

Ein Ausführungsbeispiel der Erfindung wird nachstehend anhand der Zeichnung näher erläutert. Es zeigen:

Fig. 1 ein Blockschaltbild einer integrierten Schaltung mit einer erfindungsgemäßen Testschaltung für Testsignale mit mehreren Spannungspegeln,

Fig. 2 den Signalverlauf am Testeingang für eine typische Folge von binären Testsignalen.

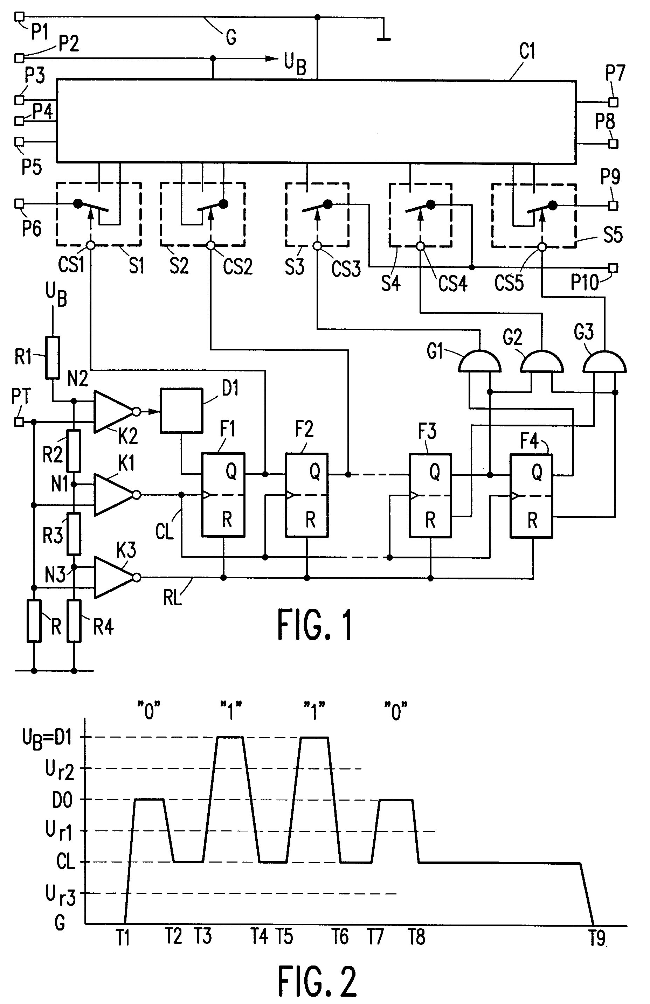

In Fig. 1 stellt der Block C1 den Kern der integrierten Schaltung dar, in dem die normale Signalverarbeitung stattfindet. Diese Kernschaltung weist Eingänge auf, die mit externen Anschlüssen P3, P4 und P5 verbunden sind, sowie Ausgänge, die mit externen Anschlüssen P7 und P8 verbunden sind. Ferner wird über einen Anschluß P1 Bezugspotential G sowie über einen Anschluß P2 die Betriebsspannung $U_B$ zugeführt.

Die Signalverarbeitungsschaltung C1, enthält eine Anzahl nicht näher dargestellte Funktionsblöcke, von denen wenigstens einige als analoge Schaltung ausgeführt sind. Von diesen Funktionsblöcken sind Eingänge und Ausgänge mit Schaltern S1 bis S5 verbunden, die entweder einfache Schalter oder Umschalter darstellen und deren Schaltzustände über Signale an Steuereingängen CS1 bis CS5 bestimmt werden. Die Schalter S1 bis S5 sind selbstverständlich als elektronische Schalter aufgebaut und hier nur vereinfacht als mechanische Schalter dargestellt.

Der Schalter S1 verbindet beispielsweise einen externen Anschluß P6 mit einer von zwei Leitungen der Signalverarbeitungsschaltung C1. In der dargestellten Stellung kann der Schalter S1 den Anschluß P1 beispielsweise mit einem Eingang eines Funktionsblocks verbinden, der im Normalbetrieb über den Anschluß P6 ein Eingangssignal empfängt, während in der anderen Schalterstellung ein Eingang eines anderen Funktionsblocks angesteuert wird, der im Normalbetrieb von außerhalb nicht zugänglich ist. Der Schalter S2 verbindet im dargestellten Schaltzustand beispielweise einen Ausgang eines ersten Funktionsblocks mit einem Eingang eines zweiten Funktionsblocks, wie dies für die normale Funktion der integrierten Schaltung erforderlich ist, während im anderen Schaltzustand der Ausgang eines dritten Funktionsblocks mit dem Eingang des zweiten Funktionsblocks verbunden wird, um beide zusammen zu testen. Statt eines Ausgangs eines dritten Funktionsblocks kann dies auch ein festes Potential sein, um beispielsweise dem Eingang des zweiten Funktionsblocks ein konstantes Potential zuzuführen und diesen unabhängig vom ersten Funktionsblock testen zu können.

Die Schalter S3 und S4 verbinden bei entsprechender Ansteuerung vorzugsweise Ausgänge von internen Funktionsblöcken mit einem externen Anschluß P10, der in diesem Falle nur als Testausgang verwendet wird. Eine andere Möglichkeit ist beim Schalter S5 dargestellt, der im dargestellten Schalterzustand einen Ausgang eines Funktionsblocks mit einem Anschluß P9 verbindet, was den normalen Betriebszustand darstellt, während bei Ansteuerung statt dessen ein Ausgang eines anderen Funktionsblocks mit dem Anschluß P9 verbunden wird, um diesen anderen Funktionsblock testen zu können. In entsprechender Weise sind noch viele andere Verbindungen von Anschlüssen interner Funktionsblöcke miteinander, mit vorgegebenen Potentialen oder mit externen Anschlüssen möglich.

Die Ansteuerung der Schalter S1 bis S5 erfolgt durch die Ausgänge von Speicherstufen F1 bis F4, deren Anzahl in der Praxis auch wesentlich größer sein kann, wie durch die gestrichelten Verbindungen zwischen den Speicherstufen F2 und F3 angedeutet ist. Dabei werden die Schalter S3 bis S5 über UND-Gatter G1 bis G3 angesteuert, die unterschiedliche Signalzustände bzw. Inhalte der Speicherstufen F3 und F4 auskodieren. Dadurch wird von den Schaltern S3 bis S5 jeweils nur einer angesteuert, während die Schalter S1 und S2 auch gleichzeitig umgeschaltet sein können. Dies hängt ab vom Inhalt der Speicherstufen F1 bis F4.

Dieser Inhalt, d.h. die darin enthaltenen Daten, werden nacheinander über den Testeingang PT eingegeben. Dieser Testeingang ist mit dem einen Eingang von drei Komparatoren K1, K2 und K3 verbunden, wobei die anderen Eingänge dieser Komparaten mit Schaltungsknoten N1, N2 und N3 verbunden sind. Diese Schaltungsknoten N1 bis N3 werden durch einen Spannungsteiler aus den Widerständen R1 bis R4 zwischen der Betriebsspannung $U_B$ und Bezugspotential G. Der Ausgang des Komparators K1 ist über eine Taktleitung CL mit Takteingängen der Speicherstufen F1 bis F4 verbunden, während der Ausgang des Komparators K3 über eine Rücksetzleitung RL mit Rücksetzeingängen R der Speicherstufen verbunden ist. Der Ausgang des Komparators K2 ist über ein Verzögerungsglied D1 mit dem Dateneingang der ersten Speicherstufe F1 verbunden, während der Dateneingang der folgenden Speicherstufen F2 bis F4 jeweils mit dem Ausgang Q der vorhergehenden Speicherstufe verbunden ist. Das Verzögerungsglied D1 ist zweckmäßig durch ein R-S-Flipflop, insbesondere durch ein einfaches R-S-Latch realisiert, das in diesem Beispiel durch den positiven Pegel des Signals auf der Taktleitung CL immer wieder zurück gestellt wird. In dieser Realisierung werden dann nur sehr geringe Anforderungen an die Taktflanke gestellt, und die Taktfrequenz kann weit variieren.

Die Funktion der Komparatoren K1 bis K3 und der daran angeschlossenen Elemente wird anhand der Fig. 2 erläutert, die einen typischen Signalverlauf am Testeingang PT zeigt. In der Fig. 2 sind ferner die Differenzspannungen $U_{r1}$, $U_{r2}$ und $U_{r3}$ an den entsprechenden Schaltungsknoten N1 bis N3 angedeutet.

Zunächst ist das Signal am Testeingang PT gleich dem Bezugspotential G und damit unterhalb der Referenzspannung $U_{r3}$, so daß der Komparator K3 ein Signal auf der Rücksetzleitung RL erzeugt, das alle Speicherstufen F1 bis F4 in den rückgesetzten Zustand bringt. Beim Zeitpunkt T1 steigt die Spannung am Testeingang PT auf einen Signalwert D0. Dieser überschreitet die Referenzspannung $U_{r3}$, wodurch das Signal am Ausgang des Komparators K3 wechselt und das Rücksetzsignal auf der Leitung RL verschwindet. Ferner wird die Referenzspannung $U_{r1}$ überschritten, wodurch das Signal am Ausgang des Komparators K1 wechselt, beispielsweise niedrig wird, wenn die Takteingänge der Speicherstufen F1 bis F4 auf eine positive Taktflanke reagieren. Dieser Signalzustand läßt sich durch entsprechende Verbindung der Eingänge des Komparators K1 herstellen. Die Referenzspannung $U_{r2}$ wird dagegen nicht überschritten, so daß das Ausgangssignal des Komparators K2 und damit das Eingangssignal der Speicherstufe F1 niedrig bleibt. Dies entspricht dem logischen Signal "0", wie in Fig. 2 über diesem Impuls angegeben ist.

Zum Zeitpunkt T2 geht das Signal am Testeingang PT auf den Signalwert CL zurück und unterschreitet dabei die Referenzspannung $U_{r1}$. Damit erzeugt der Komparator K1 eine positive Taktflanke auf der Taktleitung CL, so daß die logische "0" in die Speicherstufe F1 übernommen wird.

Zum Zeitpunkt T3 geht das Signal am Testeingang PT auf den Wert D1, der der Betriebsspannung $U_B$ entspricht. Damit wird wieder die Referenzspannung $U_{r1}$ überschritten, so daß das Signal auf der Taktleitung CL wieder niedrig wird, und außerdem wird die Referenzspannung $U_{r2}$ überschritten, so daß nun der Komparator K2 ein hohes Signal liefert, das über das Verzögerungsglied D1 dem Dateneingang der Speicherstufe F1 zugeführt wird. Zum Zeitpunkt T4 geht das Signal wieder auf den Wert CL zurück, wodurch auf der Taktleitung CL wieder eine positive Taktflanke erzeugt wird, die in die Speicherstufe F1 das hohe Signal entsprechend einer logischen "1" einschreibt, da das nun niedrige Signal am Ausgang des Komparators K2 durch das Verzögerungsglied D1 erst verzögert wirksam wird, insbesondere bei der erwähnten Realisierung durch ein D-Flipflop erst nachdem das Signal auf der Taktleitung CL den hohen Pegel erreicht hat.

Dieser Vorgang wiederholt sich zwischen den Zeitpunkt T5 und T6, wodurch erneut eine logische "1" in die Speicherstufe F1 eingeschrieben und die vorhergehende logische "1" in die Speicherstufe F2 übertragen wird. Zwischen den Zeitpunkten T7 und T8 geht das Signal am Testeingang PT ebenso wie zwischen den Zeitpunkten T1 und T2 nur auf den Signalwert D0, so daß nach dem Zeitpunkt T8 schließlich eine logische "0" in die Speicherstufe F1 eingeschrieben ist, während die Speicherstufen F2 und F3 (wenn angenommen wird, daß sich keine weiteren Speicherstufen dazwischen befinden) eine logische "1" enthalten und die Speicherstufe F4 die zuerst eingegebene logische "0" enthält. Dadurch wird über den Ausgang der Speicherstufe F2 der Steuereingang CS2 und über das Gatter G2 der Steuereingang CS4 angesteuert, so daß die Schalter S2 und S4 umschalten, während die übrigen Schalter in der dargestellten Stellung verbleiben.

Zweckmäßige Werte für die Signale D1, D0 und CL am Testeingang PT und für die Referenzspannung $U_{r1}$ bis $U_{r3}$ sind beispielsweise

$$D1 = U_B = 5\ V$$
$$U_{r2} = 4\ V$$
$$D0 = 3{,}25\ V$$
$$U_{r1} = 2{,}5\ V$$
$$CL = 1{,}75\ V$$
$$U_{r3} = 1\ V$$

$$G = 0\ V$$

Die angegebenen Referenzspannungen werden erreicht, wenn für die Widerstände R1 bis R4 des Spannungsteilers gilt

$$1{,}5 \cdot R1 = R2 = R3 = 1{,}5 \cdot R4$$

Nach dem Zeitpunkt T8 können nun bestimmten Anschlüssen P3 bis P6 insbesondere analoge Eingangssignale zugeführt werden, die Ausgangssignale an anderen Anschlüssen erzeugen. Diese Ausgangssignale werden außerhalb der integrierten Schaltung mit Signalen verglichen, die bei einer ordnungsgemäßen Funktion der getesten Funktionsblöcke in der Signalverarbeitungsschaltung C1 aufgrund der zugeführten Eingangssignale erzeugt werden müssen.

Zum Zeitpunkt T9 ist dieser Testschritt abgeschlossen, und das Eingangssignal geht nun wieder auf Bezugspotential G, wodurch auf der Rücksetzleitung RL ein Signal erzeugt wird, das alle Speicherstufen F1 bis F4 wieder in den rückgesetzten Zustand bringt. Dies ist jedoch nicht unbedingt erforderlich, wenn der Test mit einem weiteren Testschritt fortgesetzt werden soll, sondern es kann sich an den Zeitpunkt T9 unmittelbar die Eingabe eines weiteren Signals mit einem etwas anderen Verlauf als in Fig. 2 dargestellt anschließen, d.h. mit einer anderen Folge der logischen Signale "0" und "1", um andere der Schalter S1 bis S5 anzusteuern und damit andere Funktionsblöcke zu testen.

Im normalen Betrieb kann der Testeingang PT unbeschaltet bleiben, da dieser Testeingang durch den Widerstand R auf Bezugspotential G gezogen wird, wodurch der Komparator K3 auf der Rücksetzleitung RL, wie beschrieben, ein Signal zum Rücksetzen aller Speicherstufen erzeugt. Die Verbindungen der Anschlüsse der Schalter S1 usw. mit den Funktionsblöcken der Signalverarbeitungsschaltung C1 ist so gewählt, daß bei diesem Zustand der Speicherstufen F1 bis F4 alle Funktionsblöcke gemäß dem Normalbetrieb miteinander bzw. mit externen Anschlüssen verbunden sind.

Auf diese Weise, wie vorstehend beschrieben, können also auch sehr komplexe integrierte Schaltungen mit einer Vielzahl von komplex miteinander verbundenen Funktionsblöcken einfach und dennoch vollständig getestet werden.

**Patentansprüche**

1. Verfahren zum Prüfen einer integrierten Schaltung mit folgenden Schritten:
   - es werden über wenigstens einen Testeingang Folgen von Testsignalen zugeführt,
   - die Testsignale der Folge werden in der integrierten Schaltung gespeichert zum Ansteuern von Schaltern zwischen verschiedenen Schaltungspunkten der integrierten Schaltung und/oder äußeren Anschlüssen,
   - nach jeder Folge von Testsignalen wird wenigstens einem Anschluß ein vorgegebenes Eingangssignal zugeführt, und Eigenschaften des Ausgangssignals an wenigstens einem anderen Anschluß werden mit vorgegebenen Eigenschaften verglichen.

2. Verfahren nach Anspruch 1, bei dem die Testsignale mit einem von mehreren Spannungspegeln in der Form zugeführt werden, daß ein erster Spannungspegel ein logisches Signal "1", ein zweiter Spannungspegel ein logisches Signal "0" und ein dritter Pegel die Trennung zwischen zeitlich aufeinanderfolgenden logischen Signalen darstellt.

3. Integrierte Schaltungsanordnung (C1) mit Anschlüssen (P1 bis P10) nach außerhalb und mit einer Testschaltung, die über wenigstens einen Testanschluß (PT) nach außerhalb verbunden ist und enthält:
   - eine mit dem Testanschluß (PT) verbundene Impulsformanordnung (K1, K2, D) zum Abgeben von binären Signalen an einem Steuerausgang und von Taktsignalen an einem Taktausgang,
   - eine Anzahl Speicherstufen (F1 bis F4), die mit dem Steuerausgang und dem Taktausgang gekoppelt sind, um bei jedem Taktsignal am Taktausgang das vorhergehende binäre Signal am Steuerausgang in einer anderen Speicherstufe zu speichern,
   - eine Anzahl Schalter (S1 bis S5) zwischen verschiedenen Schaltungspunkten der integrierten Schaltung (C1) und/oder Anschlüssen (P6, P9, P10), wobei die Schalter Steuereingänge (CS1 bis CS5) aufweisen, die mit Ausgängen (Q) der Speicherstufen (F1 bis F4) gekoppelt sind.

4. Schaltungsanordnung nach Anspruch 3, bei der die Impulsformanordnung (K1, K2, D) wenigstens einen ersten und einen zweiten Komparator (K1, K2) mit je zwei Eingängen und einem Ausgang enthält, wobei der eine Eingang mit dem Testanschluß (PT) und der andere Eingang mit einem ersten bzw. einem zweiten Schaltungsknoten (N1, N2) für unterschiedliche Referenzspannungen verbunden ist und der Ausgang einen Signalwechsel erzeugt, wenn das Signal jedes Komparators am Testeingang die zugehörige Referenzspannung überschreitet bzw. unterschreitet, und der Ausgang des ersten Komparators (K1) mit dem Taktausgang und der Ausgang des zweiten Komparators (K2) über eine Verzögerungsschaltung (D) mit dem Steuerausgang gekoppelt ist.

5. Schaltungsanordnung nach Anspruch 4, dadurch gekennzeichnet, daß die Referenzspannung des ersten Schaltungsknotens (N1) niedriger ist als die des zweiten Schaltungsknotens (N2).

6. Schaltungsanordnung nach Anspruch 4 oder 5, dadurch gekennzeichnet, daß ein dritter Komparator (K3) mit zwei Eingängen und einem Ausgang vorgesehen ist, wobei der eine Eingang ebenfalls mit dem Testanschluß (PT) und der andere Eingang mit einem dritten Schaltungsknoten (N3) für eine Referenzspannung verbunden ist und der Ausgang mit einem Rücksetzeingang (R) aller Speicherstufen (F1 bis F4) verbunden ist, und daß die Steuereingänge (CS1 bis CS5) der Schalter (S1 bis S5) derart mit den Ausgängen (Q) der Speicherstufen (F1 bis F4) verbunden sind, daß die Schalter (S1 bis S5) bei zurückgesetzten Speicherstufen (F1 bis F4) Verbindungen für den normalen Betrieb der integrierten Schaltung (C1) herstellen.

7. Schaltungsanordnung nach Anspruch 6, dadurch gekennzeichnet, daß die Referenzspannung des dritten Schaltungsknotens (N3) niedriger als die des ersten Schaltungsknotens (N1) ist.

8. Schaltungsanordnung nach Anspruch 7, dadurch gekennzeichnet, daß der Testanschluß (PT) über einen Widerstand (R) mit Bezugspotential (G) verbunden ist.

9. Schaltungsanordnung nach einem der Ansprüche 4 bis 8, dadurch gekennzeichnet, daß wenigstens einige Schalter (S3, S4, S5) über logische Gatter (G1 bis G3) mit Ausgängen (Q) mehrerer Speicherstufen (F3, F4) gekoppelt sind.

10. Schaltungsanordnung nach einem der Ansprüche 4 bis 9, dadurch gekennzeichnet, daß die Speicherstufen (F1 bis F4) in Form eines Schieberegisters zusammengeschaltet sind.

FIG. 1

FIG. 2